# EUROPÄISCHE PATENTANMELDUNG

(11) **EP 3 945 644 A1**
(43) Veröffentlichungstag der Anmeldung: **02.02.2022**
(21) Anmeldenummer: 20195108.4
(22) Anmeldetag: 08.09.2020
(51) Int. Cl.: H01R 13/74, H01R 13/631, H01R 13/52

(54) **FRONTPLATTE FÜR EIN GEHÄUSE EINER STEUEREINRICHTUNG, GEHÄUSEBAUGRUPPE, VERBINDUNGSANORDNUNG UND FAHRZEUG**

(30) Priorität: 30.07.2020 DE 102020120184
(71) Anmelder: Rosenberger Hochfrequenztechnik GmbH & Co. KG, 83413 Fridolfing (DE)
(72) Erfinder: Anfang, Christian, 83346 Bergen (DE); Zebhauser, Martin, 83410 Laufen (DE); Zwinger, Christian, 83278 Traunstein (DE)
(74) Vertreter: Lorenz, Markus

(57) **Zusammenfassung**

Die Erfindung betrifft eine Frontplatte (5) für ein Gehäuse (4) einer Steuereinrichtung (8), aufweisend eine Durchführung (10) für einen Steckverbinder (9). Es ist vorgesehen, dass die Frontplatte (5) wenigstens ein Ausgleichselement (12, 15) aufweist, das zum Ausgleich eines toleranzbedingten Versatzes (V_{A}, V_{R}) zwischen dem Steckverbinder (9) und der Durchführung (10) in der Durchführung (10) und/oder angrenzend an die Durchführung (10) angeordnet ist.

## Beschreibung

Die Erfindung betrifft eine Frontplatte für ein Gehäuse einer Steuereinrichtung, gemäß dem Oberbegriff des Anspruchs 1.

Die Erfindung betrifft außerdem eine Gehäusebaugruppe, aufweisend eine Frontplatte und ein Gehäuse.

Die Erfindung betrifft ferner eine Verbindungsanordnung für ein Fahrzeug, insbesondere für ein Kraftfahrzeug, aufweisend eine Gehäusebaugruppe, eine Steuereinrichtung und einen Steckverbinder.

Außerdem betrifft die Erfindung ein Fahrzeug, insbesondere ein Kraftfahrzeug, aufweisend eine Verbindungsanordnung.

Steuereinrichtungen, insbesondere im Rahmen der Verwendung in Fahrzeugen auch unter dem Begriff "Steuergerät" bekannt, übernehmen unterschiedliche Steuer- und/oder Regelaufgaben innerhalb elektronischer Systeme. Hierzu können von der Steuereinrichtung beispielsweise Sensoren ausgewertet und Aktoren oder Anzeigegeräte wie Displays oder optische Signalgeber angesteuert werden. Ferner stehen einem Steuergerät in der Regel Programm- und/oder Datenspeicher und Datenverbindungen (beispielsweise Datenbussysteme) zur Kommunikation mit weiteren elektronischen Einrichtungen zur Verfügung.

Eine Steuereinrichtung ist in der Regel teilweise oder vollständig auf einer elektrischen Leiterplatte durch Verschaltung verschiedener elektrischer Bauelemente und/oder integrierter Schaltungen aufgebaut. Die Steuereinrichtung, insbesondere deren Leiterplatte, ist häufig in einer Gehäusebaugruppe aufgenommen. Zur Verbindung mit externen elektrischen Systemen, wie beispielsweise Sensoren, Aktoren, weiteren Steuereinrichtungen oder Energiequellen, sind auf der Leiterplatte in der Regel Leiterplattensteckverbinder vorgesehen. Über einen korrespondierenden Gegensteckverbinder und ein Kabel kann dann eine lösbare Verbindung mit den externen elektrischen Systemen selbst über größere Distanzen, beispielsweise zwischen einem Innenraum und dem Motorraum eines Fahrzeugs, hergestellt werden. Die einzelnen Steckverbinder werden hierzu in der Regel über jeweilige Durchbrüche in einer Frontplatte der Gehäusebaugruppe nach außen geführt.

Die Herstellung und Montage eines derartigen Systems gestaltet sich als vergleichsweise aufwändig. Die einzelnen Steckverbinder bzw. Leiterplattensteckverbinder sind aufgrund von Montagetoleranzen (beispielweise aufgrund eines Lötprozesses) und aufgrund von Fertigungstoleranzen nicht immer exakt fluchtend zur korrespondierenden Durchführung der Frontplatte positionierbar. Um dennoch in jedem Fall eine Endmontage zu ermöglichen, ist entweder eine sehr exakte und damit auch kostenintensive Herstellung und Montage der einzelnen Bauteile erforderlich oder es sind Kompromisse bei der Dichtigkeit zwischen der Durchführung und dem jeweiligen Steckverbinder einzugehen.

Insbesondere an die Robustheit und Sicherheit von Verbindungsanordnungen für die Automobilindustrie bzw. für Fahrzeuge werden hohe Anforderungen gestellt. So muss eine entsprechende Verbindungsanordnung hohen Belastungen, beispielsweise mechanischen Belastungen, standhalten und selbst unter widrigen Umgebungsbedingungen funktionsbereit bleiben. Insbesondere beim autonomen Betrieb von Fahrzeugen und Fahrerassistenzsystemen ist die Gewährleistung der Sicherheit vorrangig.

In Anbetracht des bekannten Stands der Technik besteht die Aufgabe der vorliegenden Erfindung somit darin, eine Frontplatte für ein Gehäuse einer Steuereinrichtung bereitzustellen, die im Rahmen einer Endmontage einfach montierbar ist und vorzugsweise eine hohe Dichtheit gegenüber Feuchtigkeit und Schmutz sowie eine lange Lebensdauer aufweist.

Schließlich ist es auch Aufgabe der Erfindung, eine Gehäusebaugruppe und eine Verbindungsanordnung bereitzustellen, die im Rahmen einer Endmontage einfach montierbar sind und vorzugsweise eine hohe Dichtheit gegenüber Feuchtigkeit und Schmutz sowie eine lange Lebensdauer aufweisen.

Außerdem ist es Aufgabe der Erfindung, ein verbessertes Fahrzeug bereitzustellen.

Die Aufgabe wird für die Frontplatte mit den in Anspruch 1 aufgeführten Merkmalen gelöst. Hinsichtlich der Gehäusebaugruppe wird die Aufgabe durch die Merkmale des Anspruchs 13 und betreffend die Verbindungsanordnung durch Anspruch 14 gelöst. Die Aufgabe wird außerdem für das Fahrzeug durch Anspruch 15 gelöst.

Die abhängigen Ansprüche und die nachfolgend beschriebenen Merkmale betreffen vorteilhafte Ausführungsformen und Varianten der Erfindung.

Es ist eine Frontplatte für ein Gehäuse einer Steuereinrichtung vorgesehen. Die Frontplatte weist eine Durchführung für einen Steckverbinder auf.

Die Durchführung ist vorzugsweise rechteckig, beispielsweise quadratisch, ausgebildet. Grundsätzlich kann die Durchführung allerdings eine beliebige Form aufweisen und zum Beispiel auch rund oder elliptisch ausgebildet sein. Die Durchführung kann vorzugsweise an die äußere Form des durch die Durchführung hindurchzuführenden Steckverbinders angepasst sein. Insofern mehrere Durchführungen innerhalb der Frontplatte vorgesehen sind, können die Durchführungen auch verschiedene Formen und Größen aufweisen.

Erfindungsgemäß weist die Frontplatte wenigstens ein Ausgleichselement auf, das zum Ausgleich eines toleranzbedingten Versatzes zwischen dem Steckverbinder und der Durchführung in der Durchführung und/oder angrenzend an die Durchführung angeordnet ist.

Die Frontplatte kann vorzugsweise ausgebildet sein, um derart auf das Gehäuse montiert zu werden, dass einer oder mehrere Steckverbinder, die in Richtung der Frontplatte aus dem Gehäuse herausragen, während der Montage durch jeweils korrespondierende Durchführungen der Frontplatte hindurchgeführt werden. Die Frontplatte kann damit auf eine bestehende Verbindungseinrichtung vorteilhaft aufsetzbar und optional im Falle einer Wartung wieder von dem Gehäuse abnehmbar sein.

Durch Verwendung des Ausgleichselements ist es möglich, die Durchführung in einem ausreichenden Maße größer als den Steckverbinder auszubilden, so dass die Frontplatte selbst bei großen Toleranzen und damit insbesondere im Falle des größten zu erwartenden Versatzes noch einfach und prozesssicher auf dem Gehäuse montierbar ist.

Das Ausgleichselement kann ausgebildet sein, um einen parallelen Versatz der Längsachse des Steckverbinders und der Mittelachse des Durchbruchs und/oder einen Kippwinkel zwischen der Längsachse des Steckverbinders und der Mittelachse des Durchbruchs auszugleichen. Auch ein Versatz in Axialrichtung zwischen Steckverbinder und Durchbruch kann optional durch das Ausgleichselement ausgeglichen oder zumindest berücksichtigt werden.

Das Ausgleichselement kann grundsätzlich verschiedene Funktionalitäten bereitstellen, beispielsweise eine Dichtung, eine Schirmungsübergabe und/oder eine Befestigung. Auf die einzelnen, optional realisierbaren Funktionen des Ausgleichselements wird nachfolgend noch näher eingegangen.

In einer vorteilhaften Weiterbildung der Erfindung kann vorgesehen sein, dass die Durchführung eine Nut zur Aufnahme des Ausgleichselements und/oder eine Stufe zur Auflage des Ausgleichselements aufweist.

Es können auch mehrere Nuten und/oder Stufen innerhalb der Durchführung vorgesehen sein, insbesondere eine jeweilige Nut bzw. Stufe pro Ausgleichselement.

Die Nuten können teilringförmig oder vorzugsweise vollständig ringförmig umlaufend innerhalb der Innenwände der Durchführung ausgebildet sein. Auch die Stufen können teilringförmig oder vorzugsweise vollständig ringförmig innerhalb der Durchführung ausgebildet sein. Auch einzelne Auflageflächen innerhalb der Durchführung oder einzelne Ausnehmungen innerhalb der Seitenwände der Durchführung können allerdings vorgesehen sein.

Gemäß einer Weiterbildung der Erfindung kann vorgesehen sein, dass das Ausgleichselement teilringförmig oder ringförmig ausgebildet ist.

Vorzugsweise ist das Ausgleichselement ringförmig ausgebildet bzw. entlang seines Umfangs vollständig geschlossen.

Das Ausgleichselement kann einteilig oder mehrteilig ausgebildet sein.

Das Ausgleichselement kann auch aus mehreren entlang des Umfangs der Durchführung verteilt angeordneten Einzelkomponenten ausgebildet sein. Bei den Einzelkomponenten kann es sich vorzugsweise um Federelemente handeln, beispielsweise Spiralfedern, Blattfedern und/oder Druckfedern. Die Einzelkomponenten, insbesondere die Federelemente, können zwischen der Durchführung und dem Steckverbinder angeordnet sein.

Gemäß einer Weiterbildung der Erfindung kann vorgesehen sein, dass zumindest eines der Ausgleichselemente als Dichtelement ausgebildet ist. Das Ausgleichselement kann folglich eine dichtende Funktion aufweisen.

Das Dichtelement kann den Innenraum es Gehäuses gegen das Eindringen von Feuchtigkeit, Staub, Schmutz, etc. abdichten. Gleichzeitig kann der Versatz zwischen dem Steckverbinder und der Durchführung ausgeglichen werden.

Es können auch mehrere Dichtelemente pro Durchführung vorgesehen sein (axial und/oder entlang des Umfangs der Durchführung versetzt), vorzugsweise ist allerdings genau ein Dichtelement pro Durchführung vorgesehen.

Das Dichtelement ist vorzugsweise an der Innenwandung der Durchführung positioniert und gegebenenfalls in der Durchführung befestigt oder gehalten / gesichert.

Das Dichtelement kann grundsätzlich aber auch lediglich angrenzend an die Durchführung angeordnet sein und dann vorzugsweise radial in Richtung auf die Mittelachse der Durchführung in die Durchführung hineinragen. Optional kann das Dichtelement auf der Stirnseite der Frontplatte befestigt sein.

Vorzugsweise liegt das Dichtelement in seinem montierten Zustand auf einer Stufe innerhalb der Durchführung auf. Im montierten Zustand des Steckverbinders kann das Dichtelement dann optional zwischen der Stufe der Durchführung und einem Vorsprung des Steckverbinders angeordnet sein. Das Dichtelement kann allerdings auch innerhalb einer Nut der Durchführung angeordnet sein.

In einer Weiterbildung der Erfindung kann vorgesehen sein, dass das Dichtelement mehrere Dichtlippen aufweist, die entlang einer Mittelachse des Dichtelements in Axialrichtung zueinander versetzt sind.

Vorzugsweise sind die Dichtlippen äquidistant zueinander versetzt.

Vorzugsweise ist das Dichtelement als Dichtring ausgebildet.

Das Dichtelement ist vorzugsweise aus Silikon, Naturkautschuk, Gummi oder einem anderen Elastomer ausgebildet.

In einer Weiterbildung der Erfindung kann vorgesehen sein, dass zumindest eines der Ausgleichselemente als Schirmelement ausgebildet ist, um eine elektrische Verbindung zwischen einem Außenleiter des Steckverbinders und der Frontplatte herzustellen.

Das Ausgleichselement kann somit ergänzend oder alternativ auch eine schirmende Funktion aufweisen. Eine elektrische Schirmung der Frontplatte bzw. des Gehäuses ist grundsätzlich aber nur optional, weshalb ein Schirmelement bzw. eine schirmende Funktion des Ausgleichselements nicht unbedingt vorgesehen sein muss.

Durch das Schirmelement kann die Frontplatte und gegebenenfalls das mit der Frontplatte im montierten Zustand verbundene Gehäuse mit einem gemeinsamen Bezugspotenzial, beispielsweise Masse, des Steckverbinders und/oder der Steuereinrichtung verbunden werden. Die elektromagnetische Verträglichkeit der gesamten Verbindungsanordnung kann auf diese Weise verbessert sein.

Vorzugsweise ist die Frontplatte bei Verwendung eines Schirmelements aus einem Metall ausgebildet oder weist zumindest ein Metall oder eine sonstige leitfähige Komponente auf. Grundsätzlich kann die Frontplatte und/oder das Gehäuse aber auch aus einem Kunststoff ausgebildet sein oder zumindest einen Kunststoff aufweisen.

Das Schirmelement kann vorzugsweise aus einem Metall oder einem sonstigen leitfähigen Material ausgebildet sein.

Vorzugsweise weist jede Durchführung genau ein Schirmelement auf. Es können allerdings auch mehrere Schirmelemente pro Durchführung vorgesehen sein (axial und/oder entlang des Umfangs der Durchführung versetzt).

Besonders bevorzugt weist jede Durchführung genau ein Dichtelement und genau ein Schirmelement auf. Optional kann auch ein kombiniertes Dicht- und Schirmelement vorgesehen sein. Hierzu kann das vorstehend beschriebene Dichtelement beispielsweise aus einem Elastomer mit integrierten Metallpartikeln oder Metallfasern hergestellt sein.

In einer vorteilhaften Weiterbildung der Erfindung kann vorgesehen sein, dass das Schirmelement mehrere Kontaktelemente aufweist, die entlang des Umfangs des Schirmelements zueinander versetzt sind.

Vorzugsweise sind die Kontaktelemente äquidistant zueinander versetzt.

Eine möglichst vollumfängliche elektrische Kontaktierung zwischen der Frontplatte und dem Steckverbinder kann zur Bereitstellung einer besonders hohen elektromagnetischen Verträglichkeit und der Eignung der Verbindungsanordnung für die Hochfrequenztechnik beitragen.

Grundsätzlich können beliebige Arten von Kontaktelementen vorgesehen sein, beispielsweise gefederte oder ungefederte Kontaktstifte, Schleifkontakte, Kontaktpunkte, Kontaktflächen etc.

In einer Weiterbildung der Erfindung kann insbesondere vorgesehen sein, dass die Kontaktelemente als Federlaschen ausgebildet sind.

Beispielsweise kann das Schirmelement in der Art eines Federkorbs ausgebildet sein. Durch die gefederten Federlaschen kann ein Versatz zwischen der Durchführung und dem Steckverbinder besonders vorteilhaft ausgeglichen werden.

In einer Weiterbildung der Erfindung können zwei Gruppen von Federlaschen vorgesehen sein. Eine erste Gruppe von inneren Federlaschen kann ausgebildet sein, um den Außenleiter des Steckverbinders zu kontaktieren. Eine zweite Gruppe von äußeren Federlaschen kann ausgebildet sein, um die Frontplatte zu kontaktieren.

Gegebenenfalls kann allerdings auch nur eine einzige Gruppe von Federlaschen vorgesehen sein, deren Federlaschen ausgebildet sind, um den Außenleiter des Steckverbinders einerseits und die Frontplatte andererseits zu kontaktieren. Die Federlaschen können hierzu mehrere Knick- bzw. Biegestellen aufweisen und/oder einen kurvigen Verlauf ausbilden.

In einer vorteilhaften Weiterbildung der Erfindung kann vorgesehen sein, dass die Federlaschen mit einem jeweiligen ersten Endabschnitt an dem Schirmelement angebunden sind und einen jeweiligen freien, zweiten Endabschnitt aufweisen, um den Außenleiter des Steckverbinders bzw. um die Frontplatte zu kontaktieren. Es sind somit vorzugsweise einseitig angebundene Federlaschen vorgesehen.

Grundsätzlich können allerdings auch Federlaschen vorgesehen, die an beiden Enden bzw. mit beiden Endabschnitten an dem Schirmelement angebunden sind und den Außenleiter des Steckverbinders und/oder die Frontplatte mit einem zwischen den jeweiligen Endabschnitten verlaufenden, mittleren Abschnitt kontaktieren. Die Verwendung von einseitig angebundenen Federlaschen ist allerdings aus Gründen der einfacheren Herstellbarkeit des Schirmelements bevorzugt.

In einer vorteilhaften Weiterbildung der Erfindung kann vorgesehen sein, dass die Federlaschen derart ausgerichtet sind, dass sich deren freier, zweiter Endabschnitt von der Frontplatte weg erstreckt.

Bei dieser Variante kann das Schirmelement beispielsweise mit einer die beiden Gruppen von Federlaschen verbindenden Basis auf einer Stufe innerhalb der Durchführung oder angrenzend an die Durchführung flächig aufliegen. Das Schirmungselement kann dadurch besonders nahe an der Frontplatte positioniert sein. Die Montage und die Befestigung eines derart ausgebildeten Schirmelements können besonders einfach sein.

In einer Weiterbildung der Erfindung kann alternativ vorgesehen sein, dass die Federlaschen derart ausgerichtet sind, dass sich deren freier, zweiter Endabschnitt in Richtung der Frontplatte erstreckt.

Bei dieser Variante kann ein Einführen des Steckverbinders in die Durchführung aufgrund der in Montagerichtung weisenden inneren Federlaschen vereinfacht sein. Insbesondere kann auch eine Beschädigung der Federlaschen im Falle eines zu großen Versatzes zwischen dem Steckverbinder und der Durchführung nahezu ausgeschlossen werden.

Gemäß einer Weiterbildung der Erfindung kann alternativ auch vorgesehen sein, dass die inneren Federlaschen derart ausgerichtet sind, dass sich deren freier, zweiter Endabschnitt in Richtung der Frontplatte erstreckt, wobei die äußeren Federlaschen derart ausgerichtet sind, dass sich deren freier, zweiter Endabschnitt von der Frontplatte weg erstreckt.

Bei dieser Variante kann einerseits die Montage des Schirmelements und gleichzeitig auch die Montage des Steckverbinders innerhalb der Durchführung bzw. innerhalb des Schirmelements besonders einfach sein.

In einer vorteilhaften Weiterbildung der Erfindung kann vorgesehen sein, dass die inneren Federlaschen im Bereich ihres freien, zweiten Endabschnitts wenigstens eine Biegestelle aufweisen, um für die Montage des Steckverbinders einen Fangbereich für den Steckverbinder auszubilden.

Das Aufsetzen der Frontplatte auf dem Gehäuse bzw. das Einführen der Steckverbinder in die einzelnen Durchführungen kann hierdurch selbst bei großen Toleranzen bzw. bei einem großen Versatz zwischen den Steckverbindern und den Durchführungen noch komfortabel möglich sein.

Das Schirmelement kann vorzugsweise aus einem Blechteil hergestellt sein, insbesondere im Rahmen eines Stanz-Biege-Prozesses.

In einer Weiterbildung kann vorgesehen sein, dass die Frontplatte wenigstens eine Montagestruktur aufweist, die zur Befestigung des Steckverbinders und/oder des Ausgleichselements an der Frontplatte verwendbar ist.

Die Montagestruktur kann einteilig oder mehrteilig mit der Frontplatte ausgebildet sein. Vorzugsweise ist die Montagestruktur einteilig mit der Frontplatte ausgebildet.

In einer vorteilhaften Weiterbildung der Erfindung kann vorgesehen sein, dass sich die Montagestruktur ausgehend von der Frontplatte in die Innenseite des Gehäuses erstreckt.

Vorzugsweise verläuft die Durchführung durch die Frontplatte und durch die Montagestruktur.

Vorzugsweise ist die Montagestruktur hülsenförmig ausgebildet bzw. entlang ihres Umfangs geschlossen. Dies ist aber nicht unbedingt erforderlich.

Gemäß einer Weiterbildung der Erfindung kann vorgesehen sein, dass das Ausgleichselement ausgehend von der Innenseite des Gehäuses auf die Montagestruktur aufsetzbar oder in die Montagestruktur einfügbar ist.

Grundsätzlich kann eine beliebige Befestigungstechnik (eine formschlüssige, kraftschlüssige und/oder stoffschlüssige Befestigungstechnik) zur Befestigung des Ausgleichselements in der Durchführung oder angrenzend an die Durchführung vorgesehen sein. Beispielsweise kann das Ausgleichselement in der Durchführung oder angrenzend an die Durchführung bzw. an einer beliebigen Stelle auf der Frontplatte verschraubt, vernietet, verlötet, verschweißt oder verrastet sein. Auch ein Verkleben oder sogar eine einteilige Ausgestaltung des Ausgleichselements mit der Frontplatte kann vorgesehen sein.

In einer vorteilhaften Weiterbildung der Erfindung kann insbesondere vorgesehen sein, dass die Montagestruktur ein erstes Rastelement und das Ausgleichselement ein korrespondierendes zweites Rastelement aufweist, die gemeinsam ein Rastelementpaar zum Verrasten des Ausgleichselement an der Montagestruktur ausbilden.

Vorzugsweise sind mehrere Rastelementpaare vorgesehen, beispielsweise jeweils ein Rastelementpaar an jeder Ecke der Durchführung.

Beispielsweise kann genau ein Rastelementpaar, zwei Rastelementpaare oder mehr Rastelementpaare, drei Rastelementpaare oder mehr Rastelementpaare, vier Rastelementpaare oder mehr Rastelementpaare, fünf Rastelementpaare oder mehr Rastelementpaare, sechs Rastelementpaare oder noch mehr Rastelementpaare vorgesehen sein. Ganz besonders bevorzugt sind genau vier Rastelementpaare vorgesehen.

Vorzugsweise sind die Rastelementpaare äquidistant voneinander entlang des Umfangs der Durchführung bzw. des Ausgleichselements verteilt angeordnet.

Es kann vorgesehen sein, dass das erste Rastelement der Montagestruktur als Rastausnehmung und das zweite Rastelement des Ausgleichselements als Rasthaken ausgebildet ist - oder umgekehrt.

Insbesondere ein als Schirmelement ausgebildetes Ausgleichselement kann unter Verwendung einer Kombination aus Rastausnehmung und Rasthaken vorteilhaft an der Frontplatte, insbesondere der Montagestruktur der Frontplatte, befestigbar sein.

In einer vorteilhaften Weiterbildung der Erfindung kann alternativ oder zusätzlich aber auch vorgesehen sein, dass das Ausgleichselement Öffnungen zur Durchführung korrespondierender Stifte oder Stege der Montagestruktur aufweist, wobei die Stifte oder Stege umformbar sind, um in deren umgeformtem Zustand (insbesondere in einem gestauchten Zustand) einen Formschluss für das Ausgleichselement auszubilden.

Die Befestigung mittels der Stifte/Stege und der Öffnungen des Ausgleichselements kann in der Art eines Durchsetzfügeprozesses bzw. Clinchprozesses erfolgen.

Es kann im Rahmen der Erfindung auch vorgesehen sein, dass das wenigstens eine Ausgleichselement als Befestigungselement zur Befestigung des Steckverbinders innerhalb der Durchführung oder an der Frontplatte dient. Das Ausgleichselement kann somit auch lediglich eine Montagefunktion bereitstellen.

In einer Weiterbildung der Erfindung kann vorgesehen sein, dass mehrere Durchführungen zur Durchführung eines jeweiligen Steckverbinders vorgesehen sind, wobei jede der Durchführungen wenigstens eines der Ausgleichselemente aufweist.

Es kann grundsätzlich aber auch nur genau eine Durchführung zur Durchführung genau eines Steckverbinders vorgesehen sein. Vorzugsweise sind allerdings mehrere Durchführungen für einen jeweiligen Steckverbinder vorgesehen, beispielsweise zwei, drei, vier, fünf, sechs, sieben, acht, neun, zehn oder noch mehr Durchführungen für einen jeweiligen Steckverbinder.

Die Erfindung betrifft auch eine Gehäusebaugruppe, aufweisend eine Frontplatte gemäß den vorstehenden und nachfolgenden Ausführungen und das bereits erwähnte Gehäuse.

Es kann somit eine vorteilhafte Gehäusebaugruppe für eine Steuereinrichtung bzw. für ein Steuergerät bereitgestellt werden, vorzugsweise mit einer Schirmungs- und/oder Dichtungsfunktion.

Die Erfindung betrifft außerdem auch eine Verbindungsanordnung für ein Fahrzeug, insbesondere für ein Kraftfahrzeug, aufweisend eine Gehäusebaugruppe gemäß den vorstehenden und nachfolgenden Ausführungen, sowie die beschriebene Steuereinrichtung und den beschriebenen Steckverbinder.

Es kann in vorteilhafter Weise eine Verbindungsanordnung mit einer Frontplatte bereitgestellt werden, wobei in jeder Durchführung der Frontplatte jeweils mindestens ein dichtendes Ausgleichselement (Dichtelement) und/oder mindestens ein schirmendes Ausgleichselement (Schirmelement) und/oder mindestens ein den Steckverbinder befestigendes Ausgleichselement (Befestigungselement) und/oder mindestens ein sonstiges toleranzausgleichendes Element angeordnet ist.

Vorzugsweise ist der Steckverbinder als elektrischer Steckverbinder ausgebildet. Grundsätzlich kann im Rahmen der Erfindung allerdings auch die Verwendung von optischen Steckverbindern oder hybriden elektrisch/optischen Steckverbindern vorgesehen sein. Insofern in der vorliegenden Beschreibung oder in den Ansprüchen auf elektrische oder elektronische Komponenten Bezug genommen wird, so kann diese Bezugnahme auch auf optische Komponenten oder elektrisch/optische Komponenten erweiterbar sein.

Der Steckverbinder ist sind nicht auf einen spezifischen Steckverbindertyp beschränkt, wobei sich die Erfindung insbesondere für elektrische Steckverbinder für die Hochfrequenztechnik eignet. Es kann sich dabei insbesondere um Steckverbinder des Typs PL, BNC, TNC, SMBA (FAKRA), SMA, SMB, SMS, SMC, SMP, BMS, HFM (FAKRA-Mini), H-MTD, BMK, Mini-Coax oder MATE-AX handeln. Der Steckverbinder kann einen oder mehrere Innenleiter und/oder Außenleiter aufweisen.

Insofern mehrere Durchführungen vorgesehen sind, können in den verschiedenen Durchführungen jeweils identische Steckverbindertypen oder aber auch verschiedene Steckverbindertypen vorgesehen sein (beispielsweise auch verschiedene Varianten von Steckverbindertypen oder verschiedene Größen/Dimensionen von Steckverbindertypen).

Die Steuereinrichtung kann als Mikroprozessor ausgebildet sein. Anstelle eines Mikroprozessors kann auch eine beliebige weitere Einrichtung zur Implementierung der Steuereinrichtung vorgesehen sein, insbesondere eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Die Steuereinrichtung kann besonders bevorzugt als Steuergerät eines Kraftfahrzeugs ausgebildet sein.

In einer vorteilhaften Weiterbildung der Erfindung kann vorgesehen sein, dass die Steuereinrichtung eine in dem Gehäuse festgelegte elektrische Leiterplatte aufweist, wobei der Steckverbinder als Leiterplattensteckverbinder ausgebildet und mit der Leiterplatte elektrisch (und/oder optisch) und mechanisch verbunden ist.

Die Erfindung betrifft auch ein Fahrzeug, insbesondere ein Kraftfahrzeug, aufweisend eine Verbindungsanordnung gemäß den vorstehenden und nachfolgenden Ausführungen.

Der Begriff "Fahrzeug" beschreibt dabei jegliches Fortbewegungsmittel, insbesondere Fahrzeuge zu Lande, zu Wasser oder in der Luft, eingeschlossen auch Raumfahrzeuge.

Schließlich betrifft die Erfindung auch ein Montageverfahren für eine Verbindungsanordnung, insbesondere für eine Verbindungsanordnung gemäß den vorstehenden und nachfolgenden Ausführungen.

Im Rahmen des Montageverfahrens kann vorgesehen sein, eine Steuereinrichtung, insbesondere eine elektrische Leiterplatte einer Steuereinrichtung, in ein Gehäuse zu montieren. Auf der Leiterplatte kann vor, während oder nach der Montage der Leiterplatte in dem Gehäuse wenigstens ein Leiterplattensteckverbinder elektrisch und mechanisch befestigt werden.

In oder auf einer Frontplatte, die wenigstens eine Durchführung für den Steckverbinder bzw. für den Leiterplattensteckverbinder aufweist, kann ein Ausgleichselement oder können mehrere Ausgleichselemente montiert werden, beispielsweise ein Dichtelement und ein Schirmelement. Das Dichtelement und/oder das Schirmelement können an oder in der Frontplatte befestigt, beispielsweise verrastet oder durch Umformen, beispielsweise Clinchen, befestigt werden.

Die Frontplatte kann auf das Gehäuse aufgesetzt werden, vorzugsweise nachdem die Leiterplatte mit den Steckverbindern in dem Gehäuse montiert wurde. Die Steckverbinder können während des Aufsetzens der Frontplatte durch die Durchführungen hindurchgeführt werden, wobei die Ausgleichselemente einen Versatz zwischen den Steckverbindern und der jeweiligen Durchführung auszugleichen vermögen.

Merkmale, die im Zusammenhang mit einem der Gegenstände der Erfindung, namentlich gegeben durch die erfindungsgemäße Frontplatte, die Gehäusebaugruppe, die Verbindungsanordnung, das Fahrzeug und das Montageverfahren beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielswiese ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: eine erfindungsgemäße Verbindungsanordnung für ein Fahrzeug, aufweisend eine Gehäusebaugruppe mit einem Gehäuse und einer Frontplatte, eine Steuereinrichtung und zwei Steckverbinder in einer perspektivischen Schnittdarstellung;
- Figur 2: eine Frontplatte gemäß einem ersten Ausführungsbeispiel der Erfindung mit Dichtelementen und mit in der Frontplatte verrasteten Schirmelementen in einer perspektivischen Schnittdarstellung;
- Figur 3: die Frontplatte der Figur 2 in einer seitlichen Schnittdarstellung;
- Figur 4: das Schirmelement der Frontplatte der Figur 2 in einer perspektivischen Einzeldarstellung;
- Figur 5: ein Dichtelement in einer perspektivischen Einzeldarstellung;
- Figur 6: eine Explosionsdarstellung / Montagedarstellung der Frontplatte der Figur 2;
- Figur 7: eine Frontplatte gemäß einem zweiten Ausführungsbeispiel der Erfindung mit Dichtelementen und mit auf der Frontplatte aufgesetzten Schirmelementen in einer perspektivischen Schnittdarstellung;
- Figur 8: die Frontplatte der Figur 7 in einer seitlichen Schnittdarstellung;
- Figur 9: das Schirmelement der Frontplatte der Figur 7 in einer perspektivischen Einzeldarstellung;
- Figur 10: eine Explosionsdarstellung / Montagedarstellung der Frontplatte der Figur 7; und
- Figur 11: eine Frontplatte gemäß einem dritten Ausführungsbeispiel der Erfindung in einer seitlichen Schnittdarstellung.

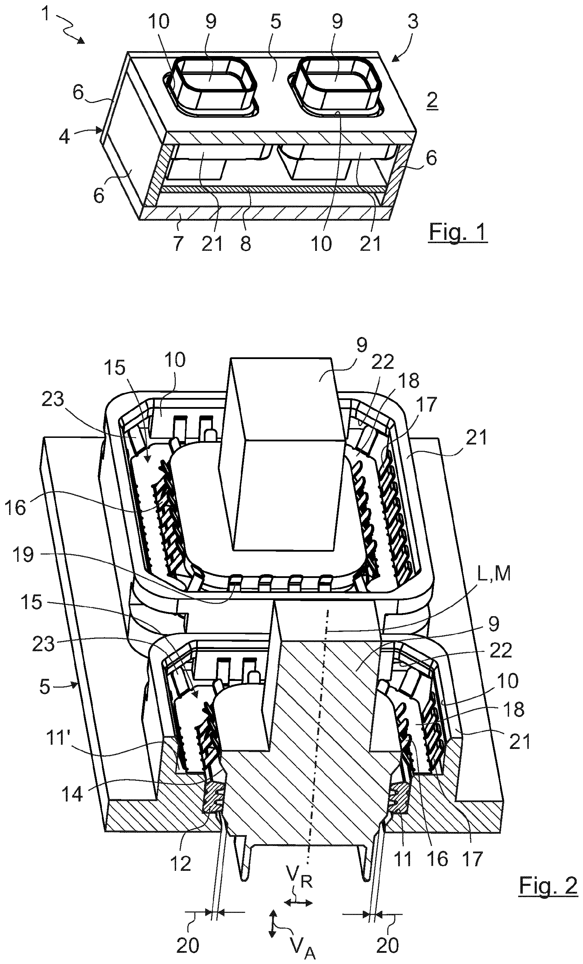

Figur 1 zeigt eine Verbindungsanordnung 1, insbesondere zur Verwendung in einem Fahrzeug 2, besonders bevorzugt in einem Kraftfahrzeug.

Die Verbindungsanordnung 1 weist eine Gehäusebaugruppe 3 mit einem Gehäuse 4 und einer Frontplatte 5 auf. Das Gehäuse 4 kann Seitenwände 6 und eine Grundplatte 7 aufweisen.

Die Verbindungsanordnung 1 umfasst außerdem eine Steuereinrichtung 8, die beispielsweise als elektrische Leiterplatte ausgebildet sein oder zumindest eine Leiterplatte aufweisen kann. Die Steuereinrichtung 8 ist in Figur 1 lediglich stark vereinfacht als Leiterplatte angedeutet.

Zur Verbindung mit weiteren, externen Steuereinrichtungen, Sensoren, Aktoren oder sonstigen elektrischen Systemen können Steckverbinder 9 vorgesehen sein, insbesondere die dargestellten Leiterplattensteckverbinder. In den Ausführungsbeispielen sind die Steckverbinder 9 lediglich schematisch als "Blackbox" angedeutet. Grundsätzlich kann sich die Erfindung zur Verwendung mit beliebigen Steckverbindern 9 eignen, insbesondere auch zur Verwendung mit Steckverbindern 9 unterschiedlicher Bauart.

Die Steckverbinder 9 sind durch jeweilige Durchführungen 10 in der Frontplatte 5 hindurchgeführt. Toleranzbedingt gestaltet sich die Montage der Frontplatte 5 aufgrund eines Versatzes zwischen den Steckverbindern 9 und den Durchführungen 10 häufig schwierig bis unmöglich.

Erfindungsgemäß kann ein Versatz zwischen dem Steckverbinder 9 und der jeweiligen Durchführung 10 ausgeglichen werden.

Die Frontplatte 5 kann grundsätzlich beliebig viele Durchführungen 10 zur Durchführung jeweiliger Steckverbinder 9 aufweisen. In den Ausführungsbeispielen sind lediglich zur Verdeutlichung des Prinzips genau zwei Durchführungen 10 bzw. genau zwei Steckverbinder 9 dargestellt.

Zum Ausgleich des Versatzes (axialer Versatz V_{A}, radialer Versatz V_{R} und/oder Kippwinkel zwischen der Längsachse L des Steckverbinders und der Mittelachse M der Durchführung 10, vgl. jeweils Figur 2) ist wenigstens ein Ausgleichselement 12, 15 für die jeweilige Durchführung 10 vorgesehen.

Das Ausgleichselement 12, 15 kann in der Durchführung 10 und/oder angrenzend an die Durchführung 10 angeordnet sein. Die nachfolgenden Figuren 2 bis 11 sollen lediglich schematisch und beispielhaft einige Möglichkeiten zur Realisierung der Erfindung verdeutlichen.

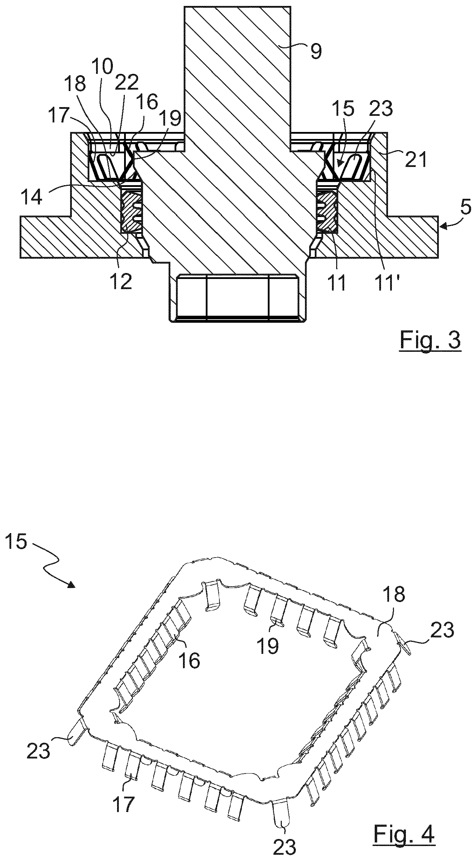

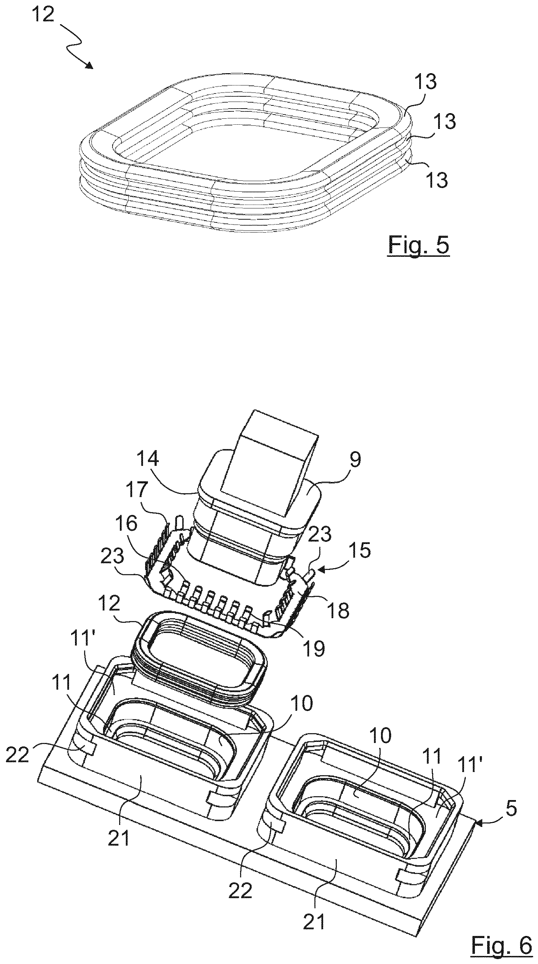

In Figur 2 ist eine Frontplatte 5 gemäß einem ersten Ausführungsbeispiel der Erfindung in einer perspektivischen Schnittdarstellung gezeigt. Die Frontplatte ist von innen bzw. ausgehend von der Innenseite des in den Figuren 2 bis 11 nicht weiter gezeigten Gehäuses 4 dargestellt. Figur 3 zeigt die Frontplatte 5 in einer geschnittenen Seitenansicht. Eine Explosionsdarstellung bzw. eine vorteilhafte Montageabfolge ist in Figur 6 dargestellt.

Die Durchführung 10 ist in den Ausführungsbeispielen stufig ausgebildet und weist eine erste Stufe 11 auf (vgl. insbesondere Figur 6), auf der ein als Dichtelement 12 ausgebildetes Ausgleichselement aufliegt. Das Dichtelement 12 ist ringförmig bzw. als Dichtring ausgebildet.

In Figur 5 ist eines der Dichtelemente 12 beispielhaft in einer perspektivischen Einzeldarstellung gezeigt. Das Dichtelement 12 weist mehrere (innere und äußere) Dichtlippen 13 auf (vgl. Figur 5), die entlang einer Mittelachse des Dichtelements 12 in Axialrichtung zueinander versetzt sind. Die Dichtlippen 13 sind vorzugsweise äquidistant zueinander versetzt.

Das Dichtelement 12 ist in seinem montierten Zustand zwischen der ersten Stufe 11 der Durchführung 10 und einem optionalen Vorsprung 14 des Steckverbinders positioniert.

Es kann auch vorgesehen sein, dass das Dichtelement 12 innerhalb einer Nut in der Durchführung 10 aufgenommen ist (in den Ausführungsbeispielen nicht gezeigt).

Das Dichtelement 12 kann zur Abdichtung gegenüber Schmutz, Staub und/oder Feuchtigkeit dienen und neben einem parallelen bzw. radialen Versatz V_{R} zwischen der Längsachse L des Steckverbinders 9 und der Mittelachse M der Durchführung 10 auch einen gewissen axialen Versatz V_{A} und/oder einen Kippwinkel ausgleichen.

Die Frontplatte 5 weist optional außerdem ein als Schirmelement 15 ausgebildetes Ausgleichselement zusätzlich zu dem Dichtelement 12 auf, um eine elektrische Verbindung zwischen einem Außenleiter des Steckverbinders 9 und der Frontplatte 5 herzustellen. Hierzu weist das Schirmelement 15 mehrere Kontaktelemente auf, die in den Ausführungsbeispielen als Federlaschen 16, 17 ausgebildet sind.

Das Schirmelement 15 des ersten Ausführungsbeispiels ist zur besseren Darstellbarkeit in Figur 4 in einer perspektivischen Einzeldarstellung gezeigt.

Die Kontaktelemente bzw. die Federlaschen 16, 17 sind entlang des Umfangs des Schirmelements 15 zueinander versetzt. Auch das Schirmelement 15 ist, wie das Dichtelement 12, vollständig ringförmig umlaufend ausgebildet. Die Kontaktelemente bzw. die Federlaschen 16, 17 sind vorzugsweise äquidistant zueinander versetzt. Auf diese Weise kann eine besonders gute Schirmung bereitgestellt werden.

In den Ausführungsbeispielen sind jeweils zwei Gruppen von Federlaschen 16, 17 vorgesehen. Eine erste Gruppe von inneren Federlaschen 16 ist ausgebildet, um den Außenleiter des Steckverbinders 9 zu kontaktieren. Eine zweite Gruppe von äußeren Federlaschen 17 ist ausgebildet, um die Frontplatte 5 zu kontaktieren. Die Federlaschen 16, 17 der Ausführungsbeispiele sind jeweils einseitig an einer Basis 18 des Schirmelements 15 angebunden. Die Federlaschen 16, 17 sind dabei mit einem jeweiligen ersten Endabschnitt an dem Schirmelement 15 angebunden und mit einem jeweiligen freien, zweiten Endabschnitt zur Kontaktierung des Außenleiters des Steckverbinders 9 bzw. der Frontplatte 5 ausgebildet.

In dem in den Figuren 2 bis 6 dargestellten Ausführungsbeispiel sind alle Federlaschen 16, 17 derart ausgerichtet, dass sich deren freier, zweiter Endabschnitt von der Frontplatte 5 weg erstreckt. Das Schirmelement 15 kann somit besonders einfach und prozesssicher montierbar sein (vgl. Figur 6). Ferner kann das Schirmelement 15 mit seiner Basis 18 vorteilhaft auf einer zweiten Stufe 11' innerhalb der Durchführung 10 aufliegen. Um auch ein möglichst einfaches Einführen der Steckverbinder 9 durch die Durchführungen 10 bei der Montage der Frontplatte 5 auf dem Gehäuse 4 zu ermöglichen, können die inneren Federlaschen 16 im Bereich ihres freien, zweiten Endabschnitts eine Biegestelle 19 aufweisen, um für die Montage des Steckverbinders 9 einen Fangbereich auszubilden.

Aufgrund der Federlaschen 16, 17 ermöglicht auch das Schirmelement 15 einen vorteilhaften Ausgleich eines Versatzes V_{A}, V_{R} zwischen dem Steckverbinder 9 und der Durchführung 10.

Durch Verwendung der erfindungsgemäßen Ausgleichselemente 12, 15 kann vorzugsweise die jeweilige Durchführung 10 derart dimensioniert sein, dass der Steckverbinder 9 selbst im Falle hoher Toleranzen noch in die Durchführung 10 einführbar ist. Die sich dann im montierten Zustand ausbildenden Spalten 20 (vgl. Figur 2) können schließlich durch die Ausgleichselemente 12, 15 ausgeglichen werden, selbst wenn diese durch den Versatz zwischen Steckverbinder 9 und Durchführung 10 ungleichmäßig verteilt sind.

Die Frontplatte 5 kann eine Montagestruktur 21 zur Befestigung des Steckverbinders 9 und/oder des Ausgleichselements 12, 15 an der Frontplatte 5 aufweisen. Die Montagestruktur 21 erstreckt sich ausgehend von der Frontplatte 5 in die Innenseite des Gehäuses 4. Die Durchführung 10 verläuft durch die Frontplatte 5 und durch die Montagestruktur 21.

Das Ausgleichselement 12, 15 kann schließlich ausgehend von der Innenseite des Gehäuses 4 auf die Montagestruktur 21 aufsetzbar sein (nachfolgend im Rahmen des zweiten Ausführungsbeispiels beschrieben) oder in die Montagestruktur 21 einfügbar sein, wie in dem ersten Ausführungsbeispiel der Fall.

In dem ersten Ausführungsbeispiel weist die Montagestruktur 21 ein erstes Rastelement auf, das als Rastausnehmung 22 ausgebildet ist. Das Ausgleichselement 12, 15 weist ein korrespondierendes zweites Rastelement auf, das als Rasthaken 23 ausgebildet ist, ähnlich der Federlaschen 16, 17. Die beiden Rastelemente 22, 23 bilden ein gemeinsames Rastelementpaar zum Verrasten des Ausgleichselements 12, 15 an der Montagestruktur 21. Vorzugsweise sind mehrere Rastelementpaare vorgesehen (im Ausführungsbeispiel genau vier Rastelementpaare), die an den jeweiligen Ecken der Durchführung 10 bzw. der Montagestruktur 21 / des Schirmelements 15 angeordnet sind.

Auch alternative Befestigungstechniken sind selbstverständlich möglich.

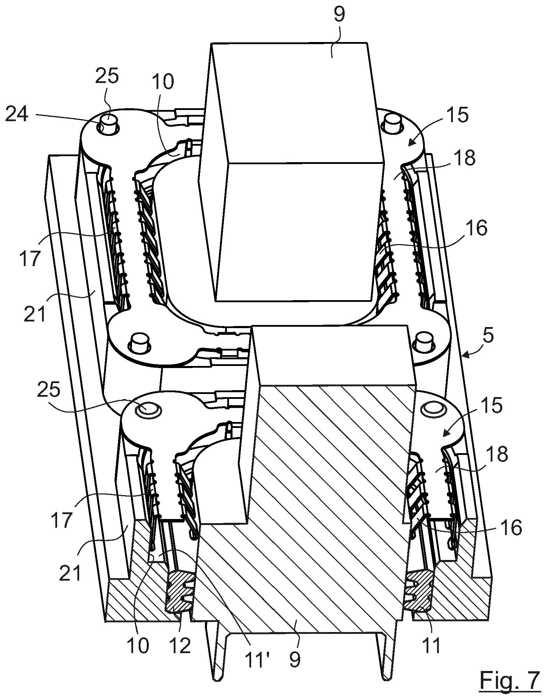

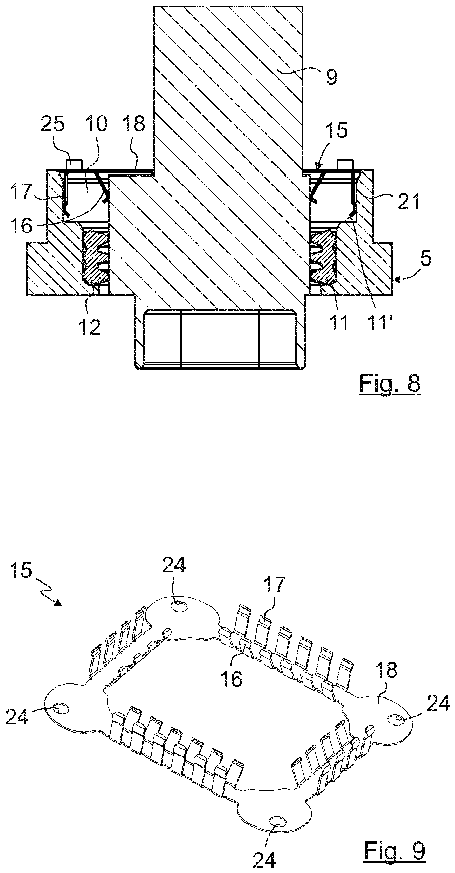

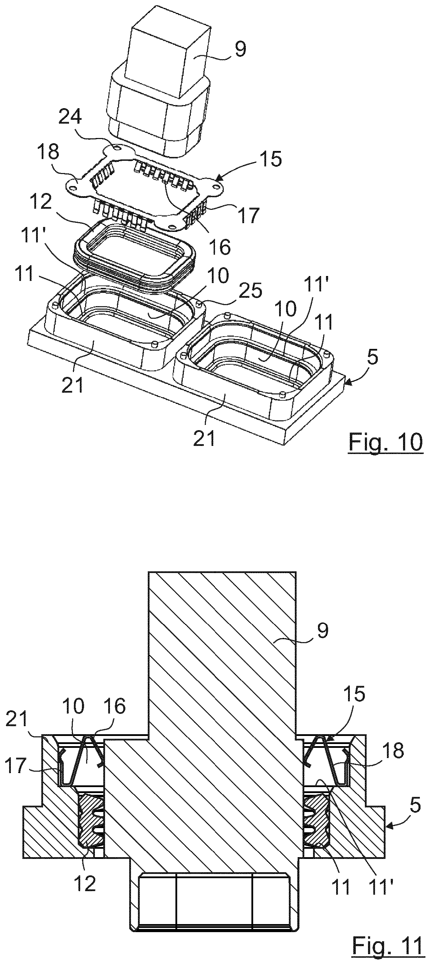

Beispielhaft wird in den Figuren 7 bis 10 ist ein zweites Ausführungsbeispiel der Erfindung gezeigt. Insbesondere soll dabei eine alternative Befestigungstechnik und eine alternative Ausgestaltung des Schirmelements 15 aufgezeigt werden. Figur 7 zeigt eine perspektivische Schnittdarstellung und Figur 8 eine seitliche Schnittdarstellung der Frontplatte 5 des zweiten Ausführungsbeispiels. Eine entsprechende Explosionsdarstellung bzw. eine vorteilhafte Montageabfolge ist in Figur 10 dargestellt.

Grundsätzlich sind die Merkmale aller Ausführungsbeispiel der vorliegenden Erfindung miteinander kombinierbar, sofern dies technisch nicht ausgeschlossen ist. Merkmale, die bereits im Rahmen des ersten Ausführungsbeispiels beschrieben wurden, werden im Hinblick auf das zweite und das nachfolgende, dritte Ausführungsbeispiels nicht erneut erläutert.

Gemäß dem zweiten Ausführungsbeispiel der Erfindung wird vorgeschlagen, dass die Federlaschen 16, 17 derart ausgerichtet sind, dass sich deren freier, zweiter Endabschnitt in Richtung der Frontplatte 5 erstreckt. Auf diese Weise kann die Montage der Frontplatte 5 auf den Steckverbindern 9 bzw. das Einführen der Steckverbinder 9 in die Durchführungen 10 vereinfacht sein, da ein noch größerer Fangbereich ausgebildet werden kann.

Das Schirmelement 15 des zweiten Ausführungsbeispiels, das beispielhaft in Figur 9 in einer perspektivischen Einzeldarstellung gezeigt ist, kann Öffnungen 24 zur Durchführung korrespondierender Stifte 25 oder Stege der Montagestruktur 21 aufweisen. Die Stifte 25 bzw. Stege können umformbar sein, um in deren umgeformtem Zustand einen Formschluss für das Ausgleichselement 12, 15 auszubilden, wie dies beispielsweise aus einem Durchsetzfügeprozess bekannt ist. In Figur 7 ist beispielhaft das vordere, geschnitten dargestellte Schirmelement 15 mit der Montagestruktur 21 über die bereits umgeformten bzw. gestauchten Stifte 25 verbunden, wohingegen das zweite, in Figur 7 oben dargestellte Schirmelement 15 noch nicht mit seiner Montagestruktur 21 verbunden wurde.

Eine weitere Möglichkeit zur Ausbildung eines Schirmelements 15 soll anhand eines dritten, in Figur 11 dargestellten Ausführungsbeispiels aufgezeigt werden.

Gemäß dem dritten Ausführungsbeispiel sind die inneren Federlaschen 16 derart ausgerichtet, dass sich deren freier, zweiter Endabschnitt in Richtung der Frontplatte 5 erstreckt. Die äußeren Federlaschen 17 sind hingegen derart ausgerichtet, dass sich deren freier, zweiter Endabschnitt von der Frontplatte 5 weg erstreckt. Auf diese Weise kann einerseits die Montage des Schirmelements 15 besonders einfach sein, wobei gleichzeitig auch ein besonders simples Aufsetzen der Frontplatte 5 auf den Steckverbindern 9 ermöglicht werden kann. Der Aufbau des Schirmelements 15 bzw. dessen Herstellung kann dann allerdings aufwändiger sein.

## Patentansprüche

1. Frontplatte (5) für ein Gehäuse (4) einer Steuereinrichtung (8), aufweisend eine Durchführung (10) für einen Steckverbinder (9),
**gekennzeichnet durch**
wenigstens ein Ausgleichselement (12, 15), das zum Ausgleich eines toleranzbedingten Versatzes (V_{A}, V_{R}) zwischen dem Steckverbinder (9) und der Durchführung (10) in der Durchführung (10) und/oder angrenzend an die Durchführung (10) angeordnet ist.

2. Frontplatte (5) nach Anspruch 1,
**dadurch gekennzeichnet, dass**
die Durchführung (10) eine Nut zur Aufnahme des Ausgleichselements (12, 15) und/oder eine Stufe (11, 11') zur Auflage des Ausgleichselements (12, 15) aufweist.

3. Frontplatte (5) nach Anspruch 1 oder 2,
**dadurch gekennzeichnet, dass**
das Ausgleichselement (12, 15) teilringförmig oder ringförmig ausgebildet ist.

4. Frontplatte (5) nach einem der Ansprüche 1 bis 3,
**dadurch gekennzeichnet, dass**
zumindest eines der Ausgleichselemente als Dichtelement (12) ausgebildet ist.

5. Frontplatte (5) nach einem der Ansprüche 1 bis 4,
**dadurch gekennzeichnet, dass**
zumindest eines der Ausgleichselemente als Schirmelement (15) ausgebildet ist, um eine elektrische Verbindung zwischen einem Außenleiter des Steckverbinders (9) und der Frontplatte (5) herzustellen, wobei das Schirmelement (15) vorzugsweise mehrere Kontaktelemente aufweist, insbesondere Federlaschen (16, 17).

6. Frontplatte (5) nach Anspruch 5,
**dadurch gekennzeichnet, dass**
zwei Gruppen von Federlaschen (16, 17) vorgesehen sind, wobei eine erste Gruppe von inneren Federlaschen (16) vorgesehen ist die ausgebildet sind, um den Außenleiter des Steckverbinders (9) zu kontaktieren, und wobei eine zweite Gruppe von äußeren Federlaschen (17) vorgesehen ist die ausgebildet sind, um die Frontplatte (5) zu kontaktieren.

7. Frontplatte (5) nach Anspruch 5 oder 6,
**dadurch gekennzeichnet, dass**
die Federlaschen (16, 17) mit einem jeweiligen ersten Endabschnitt an dem Schirmelement (15) angebunden sind und einen jeweiligen freien, zweiten Endabschnitt aufweisen, um den Außenleiter des Steckverbinders (9) bzw. die Frontplatte (5) zu kontaktieren, wobei
a) die Federlaschen (16, 17) derart ausgerichtet sind, dass sich deren freier, zweiter Endabschnitt von der Frontplatte (5) weg erstreckt; oder
b) die Federlaschen (16, 17) derart ausgerichtet sind, dass sich deren freier, zweiter Endabschnitt in Richtung der Frontplatte (5) erstreckt; oder
c) die inneren Federlaschen (16) derart ausgerichtet sind, dass sich deren freier, zweiter Endabschnitt in Richtung der Frontplatte (5) erstreckt, wobei die äußeren Federlaschen (17) derart ausgerichtet sind, dass sich deren freier, zweiter Endabschnitt von der Frontplatte (5) weg erstreckt.

8. Frontplatte (5) nach einem der Ansprüche 6 oder 7,
**dadurch gekennzeichnet, dass**
die inneren Federlaschen (16) eine Biegestelle (19) aufweisen, vorzugsweise im Bereich ihres freien, zweiten Endabschnitts, um für die Montage des Steckverbinders (9) einen Fangbereich für den Steckverbinder (9) auszubilden.

9. Frontplatte (5) nach einem der Ansprüche 1 bis 8,
**gekennzeichnet durch**
eine Montagestruktur (21) zur Befestigung des Steckverbinders (9) und/oder des Ausgleichselements (12, 15) an der Frontplatte (5).

10. Frontplatte (5) nach Anspruch 9,
**dadurch gekennzeichnet, dass** sich die Montagestruktur (21) ausgehend von der Frontplatte (5) in die Innenseite des Gehäuses (4) erstreckt, wobei die Durchführung (10) durch die Frontplatte (5) und durch die Montagestruktur (21) verläuft.

11. Frontplatte (5) nach Anspruch 9 oder 10,
**dadurch gekennzeichnet, dass**
das Ausgleichselement (12, 15) ausgehend von der Innenseite des Gehäuses (4) auf die Montagestruktur (21) aufsetzbar oder in die Montagestruktur (21) einfügbar ist.

12. Frontplatte (5) nach einem der Ansprüche 1 bis 11,
**dadurch gekennzeichnet, dass**
mehrere Durchführungen (10) zur Durchführung eines jeweiligen Steckverbinders (9) vorgesehen sind, wobei jede der Durchführungen (10) wenigstens eines der Ausgleichselemente (12, 15) aufweist.

13. Gehäusebaugruppe (3), aufweisend eine Frontplatte (5) nach einem der Ansprüche 1 bis 12 und das Gehäuse (4).

14. Verbindungsanordnung (1) für ein Fahrzeug (2), insbesondere für ein Kraftfahrzeug, aufweisend eine Gehäusebaugruppe (3) nach Anspruch 13, die Steuereinrichtung (8) und den Steckverbinder (9).

15. Fahrzeug (2), insbesondere Kraftfahrzeug, aufweisend eine Verbindungsanordnung (1) nach Anspruch 14.
